(19) Europäisches Patentamt / European Patent Office / Office européen des brevets

(11) **EP 1 294 091 B1**

(12) **EUROPÄISCHE PATENTSCHRIFT**

(45) Veröffentlichungstag und Bekanntmachung des Hinweises auf die Patenterteilung:
**02.01.2008 Patentblatt 2008/01**

(51) Int Cl.:
***H03H 11/12*** *(2006.01)*

(21) Anmeldenummer: **01122322.9**

(22) Anmeldetag: **18.09.2001**

(54) **Aktives Tiefpassfilter**

Active lowpass filter

Filtre passe-bas actif

(84) Benannte Vertragsstaaten:
**AT BE CH CY DE DK ES FI FR GB GR IE IT LI LU MC NL PT SE TR**

(43) Veröffentlichungstag der Anmeldung:
**19.03.2003 Patentblatt 2003/12**

(73) Patentinhaber: **Endress + Hauser Flowtec AG**
**4153 Reinach/BL (CH)**

(72) Erfinder:
• **Simon, Antoine**
**68300 St. Louis (FR)**
• **Ringier, Robert**
**4144 Arlesheim (CH)**

(74) Vertreter: **Andres, Angelika Maria et al**
**Endress+Hauser (Deutschland) AG+Co. KG**
**PatServe**
**Colmarer Strasse 6**
**79576 Weil am Rhein (DE)**

(56) Entgegenhaltungen:
**US-A- 2 623 947     US-A- 5 576 497**

• **H.J.KOWALSKI: "VEREINFACHTE DIMENSIONIERUNG AKTIVER RC-SCHALTUNGEN" RADIO FERNSEHEN ELEKTRONIK., Bd. 35, Nr. 2, 1986, XP002188463 VEB VERLAG TECHNIK. BERLIN., DE ISSN: 1436-1574**

**Beschreibung**

Die Erfindung betrifft ein aktives Tiefpassfilter, das mittels Operationsverstärkern, Widerständen und Kondensatoren realisiert ist.

Aktive Filter, insb. aktive Tiefpassfilter, sind z.B. in dem Buch von P. Horowitz und W. Hill, "The Art of Electronics", 2. Auflage, 1989, Seiten 263 bis 284, beschrieben. Es werden u.a. zwei Arten von Tiefpassfiltern unterschieden, nämlich Butterworth- und Tschebyscheff-Filter (English: Chebyshev filter). Eine weitere Art, die Bessel-Filter, sind für die Erfindung ohne Interesse.

Die Steilheit S des Amplitudenverlaufs der komplexen Übertragungsfunktion an der Grenze vom Durchlass- in den Sperrbereich des Filters ist von der sogenannten Ordnung n des Filters abhängig - im Englischen wird für Ordnung "pole" gesagt. Je höher die Ordnung (Pole-Anzahl) n ist, um so größer ist die Steilheit S, und es gilt: S = -20n dB/Frequenz-Zehnerpotenz (dB = Dezibel).

Die Eigenschaften von Tiefpassfiltern sind auch in dem Buch von U. Tietze, Ch. Schenk, "Electronic Circuits - Design and Applications", New York, 1991, Kapitel 14 beschrieben. Es wird eine allgemeine komplexe Übertragungsfunktion $B(P)$ eines Tiefpasses abgeleitet:

$$B(P) = B_0/(1+c_1 P+c_2 P^2+ \ldots c_n P^n) \qquad (1)$$

In Gleichung (1) sind $c_1$, $c_2$, $c_n$ Konstanten; $P = p/(2\pi f_g)$ ist die normierte komplexe Frequenzvariable, wobei $p = j2\pi f + \sigma$ ist; $f$ ist die Frequenzvariable; $j = (-1)^{1/2}$ ist die imaginäre Eins; $n$ ist die bereits erwähnte Ordnungszahl des Filters und $f_g$ die Grenzfrequenz, die i.a. die sogenannte 3-dB-Frequenz ist; das ist die Frequenz, bei der der Amplitudenverlauf auf -3 dB abgesunken ist. Für zu filternde sinusförmige Signale ist $\sigma$ gleich null und es gilt:

$$P = j\Omega \qquad (2)$$

Das Quadrat $|B|^2$ des (mathematischen) Betrags $|B|$ der komplexen Übertragungsfunktion $B(P)$ ist das oben erwähnte, von der Frequenz $f$ abhängige Amplitudenverhältnis A:

$$A(f) = |B|^2 \qquad (3)$$

Aufbauend auf den Gleichungen (1) bis (3) ist in dem Buch von U. Schenk et al. für die beiden erwähnten Filterarten das jeweilige Amplitudenverhältnis $A_{bw}$ (Butterworth) bzw. $A_{ch}$ (Tschebyscheff) definiert:

$$A_{bw} = A_0^2/(1+\Omega^{2n}) \qquad (4)$$

$$A_{ch} = aA_0^2/\{1+\epsilon^2 T_n^2(x)\} \qquad (5)$$

Darin ist $T_n(x)$ das jeweilige sogenannte Tschebyscheff-Polynom der Ordnung n. Für ungerade n ist $a = 1$ und für gerade n ist $a = 1+\epsilon^2$. Somit hat das Amplitudenverhältnis $A_{ch}$ eine Welligkeit mit einem Maximalwert $A_{chmx}$ und mit einem Minimalwert $A_{chmn}$; diese beiden Werte sind mit $\epsilon$ wie folgt verknüpft: $A_{chmx}/A_{chmn} = (1+\epsilon^2)^{1/2}$.

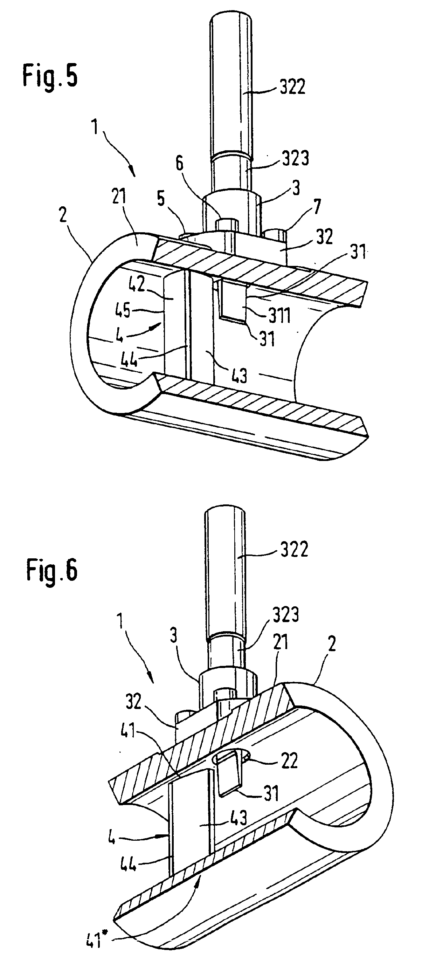

Ein seit langem übliches und auch in den genannten Büchern beschriebenes aktives Filter zweiter Ordnung ist die Sallen-Key-Schaltung, die es entweder als Sallen-Key-Tiefpass oder als Sallen-Key-Hochpass gibt und deren allgemeine Form im genannten Buch von P. Horowitz et al. als "spannungs-gesteuertes Spannungsquellen-Filter" (voltage-controlled voltage-source filter) bezeichnet wird, vgl. Seiten 273/274 in Verbindung mit Fig. 5.16 auf Seite 274. Auch das Buch von. U. Schenk et al. beschreibt ein Sallen-Key-Tiefpassfilter dieser allgemeinen Art in Kap. 14.4.3.

Ein Sallen-Key-Tiefpass allgemeiner Art umfasst demnach:

- eine Eingangs-Serienschaltung aus einem eingangs-seitigen Widerstand mit einem Widerstandswert r1 und aus einem eingangs-abgewandten Widerstand mit einem Widerstandswert r2,
- einen Operationsverstärker, von dem

-- ein nicht-invertierender Eingang an der Serienschaltung und über einen Kondensator mit einer Kapazität c1 am Schaltungsnullpunkt liegt,
-- ein invertierender Eingang über einen Widerstand mit einem Widerstandswert r am Schaltungsnullpunkt und über einen Widerstand mit einem Widerstandswert $(\alpha-1)r$ an einem Ausgang des Operationsverstärkers liegt, und
-- der Ausgang über einen Kondensator mit einer Kapazität c2 am eingangs-seitigen Widerstand und am eingangs-abgewandten Widerstand liegt,
-- wobei mit $\alpha$ die Spannungsverstärkung des Operationsverstärkers bezeichnet ist.

Ferner ist im Buch von P. Horowitz et al., Seiten 279/280 und im Buch von U. Schenk et al., Kap. 2.6 ein passives Doppel-T-Filter beschrieben, das umfasst:

- eine erste Serienschaltung aus einem eingangs-seitigen Widerstand mit einem Widerstandswert R1 und aus einem ausgangs-seitigen Widerstand mit einem Widerstandswert R2, der gleich dem Widerstandswert R1 ist,
- eine der ersten Serienschaltung parallelgeschaltete zweite Serienschaltung aus einem eingangs-seitigen Kondensator mit einer Kapazität C1 und aus einem ausgangs-seitigen Kondensator mit einer Kapazität C2, die gleich der ersten Kapazität C1 ist,
- einen den ersten und den zweiten Widerstand mit einem Schaltungsnullpunkt verbindenden dritten Kondensator mit einer Kapazität C3, die doppelt so groß wie die Kapazität C1 ist, und
- einen den ersten und den zweiten Kondensator mit dem Schaltungsnullpunkt verbindenden dritten Widerstand mit einem Widerstandswert R3, der halb so groß wie der Widerstandswert R1 ist.

Dieses Doppel-T-Filter ist ein Sperrfilter ("notch filter") für eine bestimmte Frequenz, und dessen Amplitudenverhältnis steigt im Frequenzbereich oberhalb und unterhalb der Sperrfrequenz von einem Minimalwert aus an. Im Buch von P. Horowitz et al., Seite 280 wird in Verbindung mit Fig. 5.22 zur Versteilerung des Verlaufs dieses Amplitudenverhältnisses erwogen, das Doppel-T-Filter nach Art eines Sallen-Key-Filters durch Bootstrapping zu "aktivieren"; diese Erwägung wird jedoch als völlig nachteilig wieder verworfen.
Bei vielen technischen Anwendungen aktiver Tiefpassfilter ist eine sehr große Steilheit S erforderlich, z.B. wenn Ausgangssignale von physikalisch-elektrischen Wandlern, insb. von Wirbelsensoren von Vortex-Durchflussmessern, elektronisch weiterverarbeitet werden. In solchen Fällen sind Steilheiten von mindestens -100 dB/Frequenz-Zehnerpotenz erforderlich, so dass aktive Filter fünfter oder noch höherer Ordnung benötigt werden. Das bedeutet aber, dass, da pro zwei Ordnungen (Pole) ein Operationsverstärker benötigt wird, mindestens drei Operationsverstärker erforderlich sind.
In Messgeräten ist es aber aus verschiedenen Gründen (maximal zur Verfügung stehende Speise-Energie, z.B. bei Zweidraht-Betrieb, Platzbedarf der Komponenten, von den Komponenten erzeugte Verlustwärme etc.) oft erforderlich, die Zahl der Energieverbraucher so klein wie möglich zu halten. Dies bedeutet, dass die verwendeten aktiven Filter hoher Steilheit mit einer möglichst geringen Anzahl an Operationsverstärkern ausgestattet werden müssen.
Die Erfindung beschäftigt sich daher mit dem Problem, bei aktiven Tiefpassfiltern die erwähnte Steilheit S von mindestens -100 dB/Frequenz-Zehnerpotenz mittels einer möglichst kleinen Anzahl an Operationsverstärkern zu realisieren, auf jeden Fall aber mit einer kleineren Anzahl an Operationsverstärkern, als sie die übliche Filtertheorie erwarten lässt bzw. vorschreibt.
Zur Lösung dieses Problems besteht die Erfindung in einem aktiven Tiefpassfilter, das mittels Widerständen, Kondensatoren und Operationsverstärkern realisiert ist und das umfasst:

- eine mit einem zu filternden Wechselsignal gespeiste erste Filter-Teilschaltung, die enthält:

-- eingangsseitig eine erste Serienschaltung aus einem ersten Widerstand mit einem Widerstandswert R1 und aus einem zweiten Widerstand mit einem Widerstandswert R2, der ungefähr gleich dem Widerstandswert R1 ist,
-- eine der ersten Serienschaltung parallelgeschaltete zweite Serienschaltung aus einem ersten Kondensator mit einer Kapazität C1 und einem zweiten Kondensator mit einer Kapazität C2, die ungefähr gleich der Kapazität C1 ist,
-- einen den ersten und den zweiten Widerstand mit einem Schaltungsnullpunkt verbindenden dritten Kondensator mit einer Kapazität C3, die mindestens fünfmal so groß wie die Kapazität C1 ist,
-- einen den ersten und den zweiten Kondensator mit dem Schaltungsnullpunkt verbindenden dritten Widerstand mit einem Widerstandswert R3, der groß gegenüber dem halben Widerstandswert R1 und groß gegenüber dem halben Widerstandswert R2 ist,

-- einen vierten Widerstand mit einem Widerstandswert R4, der ungefähr gleich dem Widerstandswert R3 ist,

-- einen vierten Kondensator mit einer Kapazität C4, die ungefähr gleich der Kapazität C1 ist,

-- einen fünften Kondensator mit einer Kapazität C5,

-- einen fünften Widerstand mit einem Widerstandswert R5,

-- einen sechsten Widerstand mit einem Widerstandswert (k-1)R5,

-- einen ersten Operationsverstärker, von dem

--- ein Ausgang über den fünften Kondensator am zweiten Widerstand und am zweiten Kondensator liegt,

--- ein nicht-invertierender Eingang über den vierten Widerstand am zweiten Widerstand, am zweiten Kondensator und am fünften Kondensator sowie über den vierten Kondensator am Schaltungsnullpunkt liegt und

--- ein invertierender Eingang über den fünften Widerstand am Schaltungsnullpunkt sowie über den sechsten Widerstand am Ausgang liegt,

-- wobei mit k die Spannungsverstärkung des ersten Operationsverstärkers bezeichnet ist, und

- eine dem Ausgang des ersten Operationsverstärkers nachgeschaltete zweite Filter-Teilschaltung in Form eines Sallen-Key-Tiefpasses mit einem zweiten Operationsverstärker.

Entsprechend einer bevorzugten Ausgestaltung der Erfindung umfasst der Sallen-Key-Tiefpass:

- eine dritte Serienschaltung aus einem siebten Widerstand mit einem Widerstandswert R7 und aus einem achten Widerstand mit einem Widerstandswert R8,
- einen neunten Widerstand mit einem Widerstandswert R9,
- einen zehnten Widerstand mit einem Widerstandswert (k'-1)R9,
- einen sechsten Kondensator mit einer Kapazität C6,
- einen siebten Kondensator mit einer Kapazität C7 und
- den zweiten Operationsverstärker, von dem

-- ein Ausgang über den siebten Kondensator am siebten Widerstand sowie am achten Widerstand liegt und das gefilterte Wechselsignal abgibt,

-- ein nicht-invertierender Eingang über die dritte Serienschaltung am Ausgang des ersten Operationsverstärkers sowie über den sechsten Kondensator am Schaltungsnullpunkt liegt und

-- ein invertierender Eingang über den neunten Widerstand am Schaltungsnullpunkt sowie über den zehnten Widerstand am Ausgang liegt,

-- wobei mit k' die Spannungsverstärkung des zweiten Operationsverstärkers bezeichnet ist.

Die Erfindung oder die referierte Ausgestaltung dient bevorzugt der Verwendung in einer Auswerte-Elektronik für einen Wirbel-Durchflussmesser, von dem ein Wirbel-Durchflussaufnehmer ein eine Rohrwand aufweisendes und von einem zu messenden Fluid durchströmbares Messrohr umfasst,

- in dem ein Staukörper angeordnet ist, der

-- der Erzeugung Kármán'scher Wirbel im strömenden Fluid dient und

-- an mindestens einer Fixierstelle mit der Rohrwand des Messrohrs von innen verbunden ist, und

- in dem ein auf von den Wirbeln erzeugte Druckschwankungen ansprechender und mindestens ein die Druckschwankungen repräsentierendes Wirbelsignal abgebender Wirbelsensor

-- entweder stromabwärts vom Staukörper in eine Bohrung der Rohrwand des Messrohrs eingesetzt ist und diese Bohrung abdichtet,

-- oder in einer Bohrung des Staukörpers angeordnet ist,

welche Auswerte-Elektronik umfasst:

- einen dem Wirbelsensor nachgeschalteten Hochpass,
- das dem Hochpass nachgeschaltete aktive Tiefpassfilter,
- einen dem Tiefpassfilter nachgeschalteten Schmitt-Trigger,

- einen dem Schmitt-Trigger nachgeschalteten Zähler und
- eine dem Zähler nachgeschaltete Anzeige-Einheit.

Bei einer Ausgestaltung dieser Auswerte-Elektronik ist der Hochpass bevorzugt ein Tschebyscheff-Filter zweiter Ordnung mit 0,5 dB Überschwingen.

Ein Vorteil der Erfindung besteht darin, dass für Steilheiten von mindestens -100 dB/Frequenz-Zehnerpotenz anstatt von mindestens drei Operationsverstärkern nur zwei benötigt werden. Dieser Vorteil ergibt sich überraschenderweise aufgrund der geschickten Wahl der ersten Filter-Teilschaltung in Verbindung mit dem Sallen-Key-Tiefpass.

Die erste Filter-Teilschaltung besteht nämlich, wenn zunächst nur die reine Anordnung ihrer Komponenten betrachtet wird, trotz der vom erwähnten Stand der Technik geschilderten Nachteile eingangsseitig aus einem passiven Doppel-T-Filter, dem eine Stufe nach Art eines Sallen-Key-Filters zwar nachgeschaltet ist, die jedoch nicht dem Bootstrapping dient und außerdem ganz speziell nachgeschaltet ist, s. den nächsten Absatz. Ferner weicht die Bemessung des Doppel-T-Filters so sehr von der im Stand der Technik beschriebenen und oben referierten Bemessung ab, dass die genannten Nachteile des Doppel-T-Filters mit nachfolgender Sallen-Key-artiger Stufe überraschenderweise behoben sind.

Dies kann auf den von den Erfindern angewandten "Kniff" zurückgeführt werden, dass - je nach Betrachtungsweise - der eingangs-seitige Widerstand des oben referierten Sallen-Key-Tiefpasses durch das Doppel-T-Filter ersetzt ist oder dass dieser eingangs-seitige Widerstand des Sallen-Key-Tiefpasses und der ausgangs-seitige Widerstand des Doppel-T-Filters mittels ein und desselben Widerstands realisiert sind; jedenfalls führt der mit dem Ausgang des ersten Operationsverstärkers verbundene Kondensator direkt zum Ausgang des Doppel-T-Filters und nicht über den eingangsseitigen Widerstand des Sallen-Key-Filters, wie dies der Fall wäre, wenn das Doppel-T-Filter und das Sallen-Key-Filter - wie vom genannten Stand der Technik vorausgesetzt - einfach in Serie geschaltet worden wären.

Die erste Filter-Teilschaltung stellt somit gerade keine "Addition" von Doppel-T-Filter und Sallen-Key-Filter dar, sondern eine Filterstruktur mit völlig anderen, und zwar wesentlich günstigeren, Eigenschaften, als sie diese "Addition" hätte; zu weiteren Einzelheiten hierzu siehe unten.

Die Erfindung und deren bevorzugte Verwendung sowie weitere Vorteile werden nun anhand von Ausführungsbeispielen näher erläutert, die in den Figuren der Zeichnung dargestellt sind. Gleiche Teile sind in unterschiedlichen Figuren mit denselben Bezugzeichen bezeichnet, jedoch, wenn es die Übersichtlichkeit erfordert, weggelassen.

Fig. 1    zeigt ein Schaltbild eines Ausführungsbeispiels des aktiven Tiefpassfilters,

Fig. 2    zeigt ein logarithmisches Frequenz-Diagramm des Amplitudenverlaufs der Übertragungsfunktion der ersten Filter-Teilschaltung von Fig. 1,

Fig. 3    zeigt ein logarithmisches Frequenz-Diagramm des Amplitudenverlaufs der Übertragungsfunktion der zweiten Filter-Teilschaltung (Sallen-Key-Tiefpass) von Fig. 1,

Fig. 4    zeigt ein logarithmisches Frequenz-Diagramm des Amplitudenverlaufs der Übertragungsfunktion des aktiven Tiefpassfilters von Fig. 1,

Fig. 5    zeigt in Strömungsrichtung gesehen perspektivisch und teilweise aufgeschnitten einen Wirbelströmungsaufnehmer,

Fig. 6    zeigt gegen die Strömungsrichtung gesehen perspektivisch und teilweise aufgeschnitten den Wirbelströmungsaufnehmer von Fig. 5, und

Fig. 7    zeigt ein Blockschaltbild einer mit dem aktiven Tiefpassfilter der Fig. 1 bestückten Auswerte-Elektronik eines Wirbeldurchflussmessers.

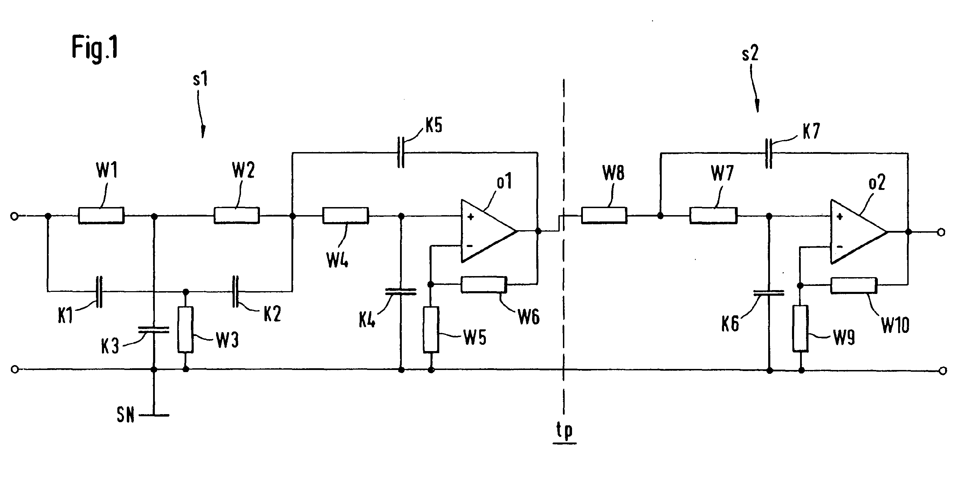

In Fig. 1 ist ein Schaltbild eines Ausführungsbeispiels eines aktiven Tiefpassfilters tp dargestellt, das mittels Widerständen, Kondensatoren und Operationsverstärkern realisiert ist. Wie durch die senkrechte gestrichelte Linie angedeutet ist, ist das Tiefpassfilter tp aus einer ersten und aus einer zweiten Filter-Teilschaltung s1 s2 zusammen gesetzt.

Die Filter-Teilschaltung s1 ist eingangs-seitig mit einem zu filternden Wechselsignal gespeist und enthält eingangsseitig eine erste Serienschaltung aus einem ersten Widerstand W1 mit einem Widerstandswert R1 und aus einem zweiten Widerstand W2 mit einem Widerstandswert R2, der ungefähr gleich dem Widerstandswert R1 ist.

Ferner ist in der Filter-Teilschaltung s1 eine der ersten Serienschaltung parallelgeschaltete zweite Serienschaltung aus einem ersten Kondensator K1 mit einer Kapazität C1 und einem zweiten Kondensator K2 mit einer Kapazität C2 vorhanden, die ungefähr gleich der Kapazität C1 ist.

Des Weiteren verbindet in der Filter-Teilschaltung s1 ein dritter Kondensator K3 mit einer Kapazität C3 den ersten und den zweiten Widerstand W1, W2, nämlich deren gemeinsamen Verbindungspunkt, mit einem Schaltungsnullpunkt SN und ein dritter Widerstand W3 mit einem Widerstandswert R3 verbindet den ersten und den zweiten Kondensator K1, K2, nämlich deren gemeinsamen Verbindungspunkt, mit dem Schaltungsnullpunkt SN. Die Kapazität C3 ist mindestens fünfmal so groß wie die Kapazität C1, und der Widerstandswert R3 ist groß gegenüber dem halben Widerstandswert R1 und groß gegenüber dem halben Widerstandswert R2.

Die bisher erläuterten Komponenten der Filter-Teilschaltung s1 bilden - allerdings nur für sich und der Struktur nach betrachtet - ein passives Doppel-T-Filter, dessen Bemessung jedoch völlig von der oben erwähnten Bemessung nach dem Stand der Technik abweicht. So schreibt die Bemessung des Standes der Technik vor:

R1 = R2; R3 = 0,5R1; C1 = C2; C3 = 2C1.

Demgegenüber schreibt die Erfindung vor:

$R1 \approx R2$; $R3 >> 0{,}5R1$; $C1 \approx C2$; $C3 > 5C1$.

Ferner sind in der Filter-Teilschaltung s1 ein vierter Widerstand W4 mit einem Widerstandswert R4, der ungefähr gleich dem Widerstandswert R3 ist, und ein vierter Kondensator K4 mit einer Kapazität C4 vorhanden, die ungefähr gleich der Kapazität C1 ist.

Schließlich weist die Filter-Teilschaltung s1 einen fünften Kondensator K5 mit einer Kapazität C5, einen fünften Widerstand W5 mit einem Widerstandswert R5, einen sechsten Widerstand W6 mit einem Widerstandswert (k-1)R5 und einen ersten Operationsverstärker o1 auf; hierin ist k die Spannungsverstärkung des Operationsverstärkers ol. Die Kapazität C5 hängt von k ab: Je größer k ist, um so kleiner kann C5 sein.

Ein Ausgang des Operationsverstärkers o1 liegt über den Kondensator K5 am Widerstand W2 und am Kondensator K2, nämlich an deren gemeinsamem Verbindungspunkt. Ein nicht-invertierender Eingang des Operationsverstärkers o1 liegt über den Widerstand W4 am Widerstand W2, am Kondensator K2 und am Kondensator K5, nämlich am Verbindungspunkt dieser letztgenannten drei Komponenten, sowie über den vierten Kondensator K4 am Schaltungsnullpunkt SN. Ein invertierender Eingang des Operationsverstärkers o1 liegt über den Widerstand W5 am Schaltungsnullpunkt SN sowie über den Widerstand W6 am Ausgang.

Dem Ausgang des Operationsverstärkers o1 ist eine zweite Filter-Teilschaltung s2 nachgeschaltet, die ein Sallen-Key-Tiefpass mit einem zweiten Operationsverstärker o2 ist. In Fig. 1 enthält der Sallen-Key-Tiefpass eine dritte Serienschaltung aus einem siebten Widerstand W7 mit einem Widerstandswert R7 und aus einem achten Widerstand W8 mit einem Widerstandswert R8. Ferner ist ein neunter Widerstand W9 mit einem Widerstandswert R9 und ein zehnter Widerstand W10 mit einem Widerstandswert (k'-1)R9 vorhanden; k' ist die Spannungsverstärkung des Operationsverstärkers o2.

Auch gibt es einen sechsten Kondensator K6 mit einer Kapazität C6 und einen siebten Kondensator K7 mit einer Kapazität C7. Die Kapazität C7 hängt von k' ab: Je größer k' ist, um so kleiner kann C7 sein.

Die Komponenten W7, W8, W9, W10, C6, C7 sind mit dem zweiten Operationsverstärkers o2 wie folgt verbunden: Ein Ausgang des Operationsverstärkers o2 liegt über den Kondensator K7 am Widerstand W7 und am Widerstand W8, nämlich an deren Verbindungspunkt, und der Ausgang gibt das gefilterte Wechselsignal ab.

Ferner liegt ein nicht-invertierender Eingang des Operationsverstärkers o2 über die dritte Serienschaltung, nämlich über die Widerstände W7 und W8, am Ausgang des Operationsverstärkers o1 sowie über den Kondensator K6 am Schaltungsnullpunkt SN. Ein invertierender Eingang des Operationsverstärkers o2 liegt über den Widerstand W9 am Schaltungsnullpunkt SN und über den Widerstand W10 am Ausgang.

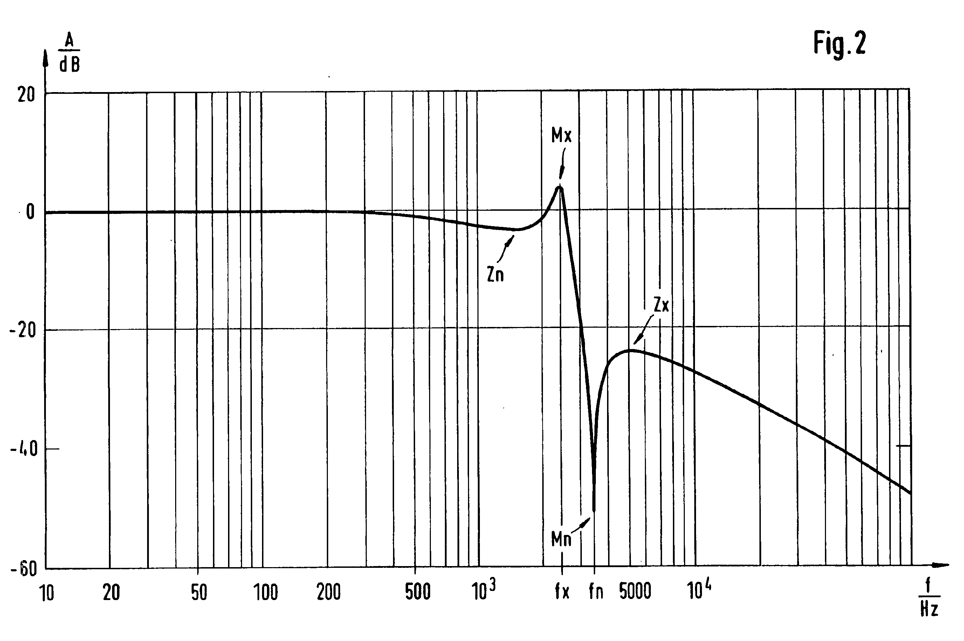

In den Fig. 2 bis 4 sind logarithmische Frequenz-Diagramme dargestellt; in den Diagrammen ist auf der Abszisse in logarithmischem Maßstab die Frequenz f und auf der Ordinate in linearem Maßstab der jeweilige Amplitudenverlauf A der Übertragungsfunktion in dB, also ebenfalls in einem logarithmischen Maß, aufgetragen. Die Diagramme wurden an einem entsprechend der Erfindung realisierten Tiefpassfilter gemessen, das die folgende Dimensionierung aufweist:

R1 = 20 kΩ; R2 = 22 kΩ; R3 = 51 kΩ; R4 = 15 kΩ;
R5 = 100 kΩ; R6 = 32 kΩ; R7 = 57 kΩ; R8 = 15 kΩ;
R9 = 100 kΩ; R10 = 4 kΩ; k = 1,32; k' = 1,04.

C1 = 1 nF; C2 = 1 nF; C3 = 10 nF; C4 = 1 nF;
C5 = 10 nF; C6 = 1 nF; C7 = 10 nF.

Der in Fig. 2 dargestellte Amplitudenverlauf A der Übertragungsfunktion der ersten Filter-Teilschaltung s1 zeigt zwischen 10 Hz und etwa 200 Hz einen konstanten Verlauf mit dem Wert 0 dB und beginnt dann bis etwa 1600 Hz auf ein Zwischenminimum Zn von etwa -2 dB abzusinken. Von da steigt die Kurve zunächst bis 0 dB bei etwa 2100 Hz an und von hier bis zu einem Maximum Mx von etwa +2 dB bei einer Maximumfrequenz fx von etwa 2300 Hz und fällt dann sehr steil zunächst auf 0 dB bei etwa 2400 Hz und dann auf ein Minimum Mn von etwa -50 dB bei einer Minimumfrequenz fn von etwa 3300 Hz ab.

Von da steigt die Kurve im Sperrbereich der Filter-Teilschaltung sehr steil bis zu einem Zwischenmaximum Zx von etwa -22 dB bei etwa 5000 Hz an, um von da weitgehend linear mit einer Steilheit S von etwa -20 dB/Frequenz-Zehnerpotenz in infinitum abzufallen. Der Verlauf zwischen etwa 200 Hz und bis zum Maximum Mx wird im Folgenden mit Überschwingverlauf bezeichnet.

Aus der Fig. 2 lässt sich durch Extrapolation ermitteln, dass zwischen dem Maximum Mx und dem Minimum Mn die mittlere Steilheit S des Amplitudenverlaufs etwa -340 dB/Frequenz-Zehnerpotenz beträgt.

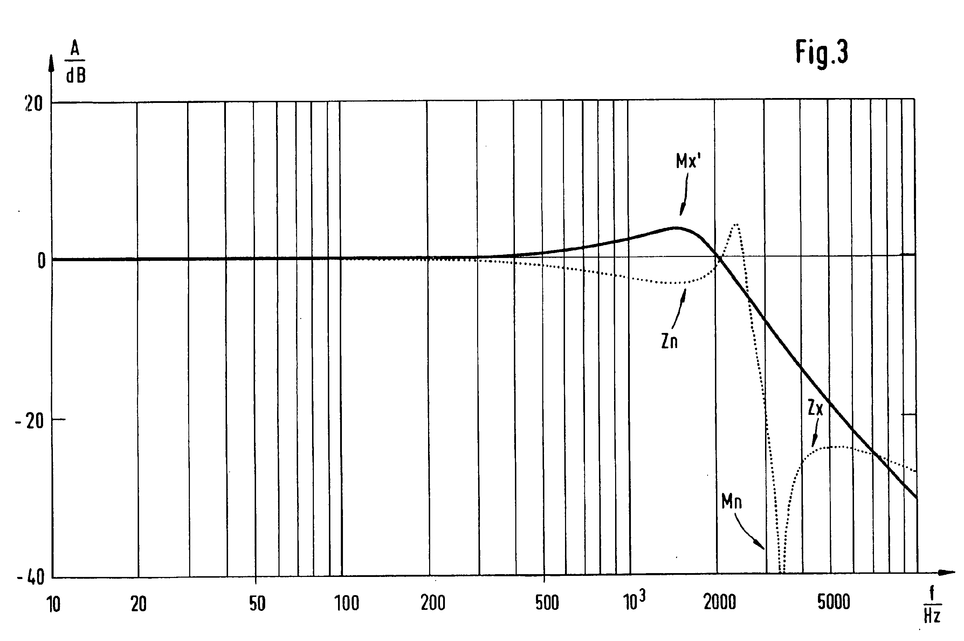

Der in Fig. 3 dargestellte Amplitudenverlauf A der Übertragungsfunktion der zweiten Filter-Teilschaltung s2 von Fig. 1, also des Sallen-Key-Tiefpasses, zeigt zwischen 10 Hz und etwa 200 Hz wieder einen konstanten Verlauf von 0 dB und beginnt dann bis etwa 1600 Hz auf ein Maximum Mx' von etwa +2 dB anzusteigen.

Von da fällt der Verlauf zunächst auf 0 dB bei etwa 2100 Hz und dann mit einer Steilheit S von etwa -46 dB/ Frequenz-Zehnerpotenz in infinitum ab. Auch hier tritt ebenso wie bei Fig. 2 ein definierter Überschwingverlauf auf, der jedoch spiegelbildlich zu dem Überschwingverlauf von Fig. 2 bezüglich der 0-dB-Linie ist.

In Fig. 3 ist gepunktet auch der Amplitudenverlauf A von Fig. 2 eingezeichnet, und es sind das Zwischenminimum Zn, das Maximum Mx und das Minimum Mn dieser Kurve wieder markiert.

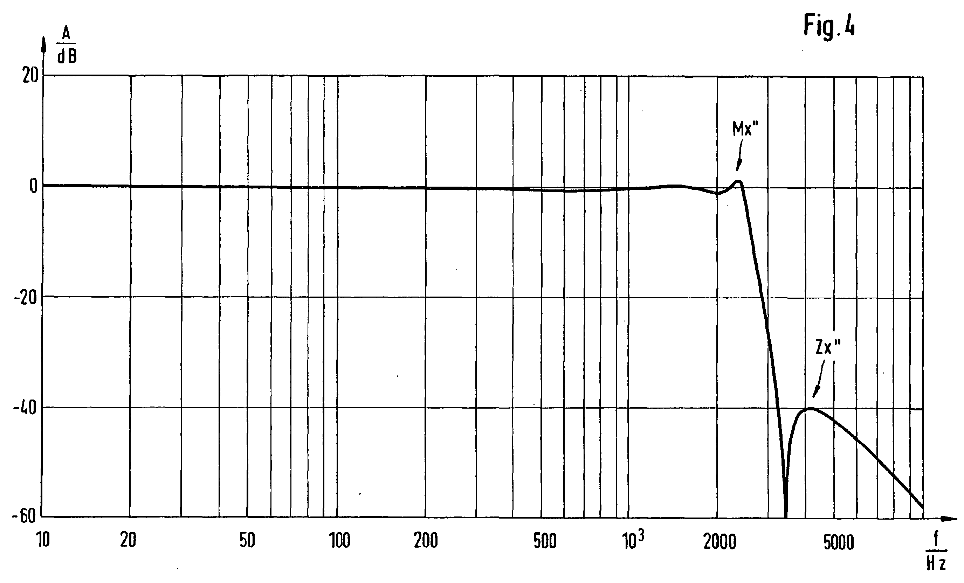

Der in Fig. 4 dargestellte Amplitudenverlauf A der Übertragungsfunktion des gesamten Tiefpassfilters tp von Fig. 1 ergibt sich durch die Überlagerung der beiden Amplitudenverläufe der Fig. 3. Ein Vergleich mit den Fig. 2 und 3 zeigt, dass das Zwischenmimimum Zn von Fig. 2 fast verschwunden ist, weil die beiden Überschwingverläufe der Filter-Teilschaltungen s1, s2 sich gerade kompensieren.

Der Vergleich zeigt ferner, dass durch diese Kompensation der Amplitudenverlauf A von Fig. 4 nicht nur bis zu etwa 200 Hz, sondern bis etwa 2000 Hz konstant ist, wenn man das zu erkennende, jedoch geringfügige Überschwingen von lediglich $\pm$ 0,6 dB zwischen etwa 300 Hz und etwa 2000 Hz als ausreichend konstant ansieht. Erst von da an steigt der Amplitudenverlauf A zu einem Maximum Mx" von etwa +1 dB bei etwa 2300 Hz an; dieses Maximum ist also nur etwa halb so groß wie das Maximum Mx von Fig. 2.

Ferner ist das Zwischenmaximum Zx von Fig. 2 zu einem Zwischenmaximum Zx" von etwa -40 dB geworden, was gegenüber dem Zwischenmaximum Zx von Fig. 2 eine Absenkung von etwa 18 dB bedeutet. Die Steilheit S zwischen dem Maximum Mx" und dem Minimum Mn" ist etwa gleich der entsprechenden Steilheit von Fig. 2 und beträgt somit wieder etwa -340 dB/Frequenz-Zehnerpotenz.

Hieran zeigt sich ganz klar der große Vorteil der Erfindung, dass nämlich mit nur zwei Operationsverstärkern eine Steilheit, die weitaus größer als -100 dB/Frequenz-Zehnerpotenz ist, und zugleich im Sperrbereich des Tiefpassfilters eine Absenkung von größer als 30 dB erreichbar sind.

Für die Steilheit von -340 dB/Frequenz-Zehnerpotenz des Ausführungsbeispiels der Fig. 2 bis 4 wäre nach der oben erläuterten Filtertheorie des Standes der Technik ein mindestens 17-poliges Filter erforderlich, das mittels neun Operationsverstärkern realisiert werden müsste; der Amplitudenverlauf eines solchen Filters hätte allerdings im Sperrbereich kein Zwischenmaximum, sondern der steile Abfall würde ohne dieses in infinitum gehen. Die Erfindung benötigt gegenüber den genannten neun Operationsverstärkern jedoch nur zwei.

In den Fig. 5 bis 7 ist eine bevorzugte Verwendung des Tiefpassfilters der Erfindung dargestellt, und zwar ist dieses eine Teil-Schaltung einer Auswerte-Elektronik für einen Wirbel-Durchflussaufnehmer 1 eines Wirbel-Durchflussmessers; zum besseren Verständnis wird zunächst anhand der Fig. 5 und 6 der Aufbau des Wirbel-Durchflussaufnehmers näher erläutert.

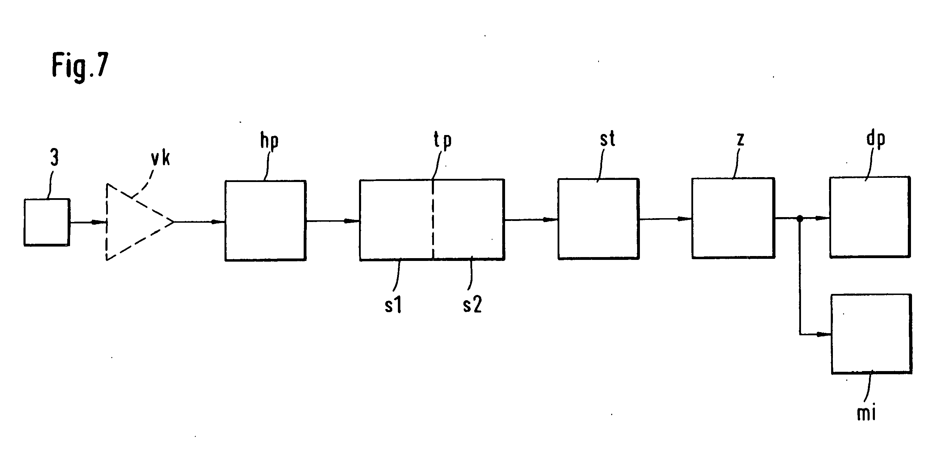

Die in den Fig. 5 und 6 gezeigten und der Übersicht dienenden perspektivischen Ansichten zeigen, einerseits in Strömungsrichtung gesehen (Fig. 5) und andererseits gegen die Strömungsrichtung gesehen (Fig. 6), den teilweise aufgeschnittenen Wirbel-Durchflussaufnehmer 1 mit einem an einer Rohrwand 21 eines Messrohrs 2 fixierten und durch eine Bohrung 22 hindurch ragenden Wirbelsensor 3. Der Wirbel-Durchflussaufnehmer 1 arbeitet mit einer Auswerte-Elektronik zusammen, deren Blockschaltbild in Fig. 7 dargestellt ist, so dass der erwähnte Wirbel-Durchflussmesser entsteht.

Als Wirbelsensor 3 dient bevorzugt ein dynamisch kompensierter Wirbelsensor mit einem kapazitiven Sensorelement, wie er in der US-A 60 03 384 beschrieben ist.

Entlang eines Durchmessers des Messrohrs 2 ist in dessen Innerem ein Staukörper 4 angeordnet, der mit dem Messrohr 2 unter Bildung einer dargestellten ersten Fixierstelle 41 und einer verdeckten zweiten Fixierstelle 41* fest verbunden ist. Das Zentrum der Bohrung 22 und das Zentrum der Fixierstelle 41 liegen auf einer Mantellinie des Messrohrs 2.

Der Staukörper 4 hat eine Prallfläche 42, gegen die im Betrieb ein zu messendes Fluid, z.B. eine Flüssigkeit, ein Gas oder ein Dampf, anströmt. Der Staukörper 4 hat ferner zwei Seitenflächen, von denen lediglich eine (vordere) Seitenfläche 43 in den Fig. 5 und 6 zu sehen ist. Von der Prallfläche 42 und den Seitenflächen werden zwei Abrisskanten gebildet, von denen lediglich eine (vordere) Abrisskante 44 vollständig und eine (hintere) Abrisskante 45 andeutungsweise in Fig. 1 zu sehen sind. Der Staukörper 4 der Fig. 5 und 6 hat im wesentlichen die Form einer geraden Dreieck-Säule, also einer Säule mit einem dreieckigen Querschnitt. Es können jedoch auch andere übliche Formen des Staukörpers verwendet werden.

Durch das Anströmen des Fluids gegen die Prallfläche 42 bildet sich stromabwärts vom Staukörper 4 eine Kármán'sche Wirbelstraße im Fluid dadurch aus, dass an jeder Abrisskante abwechselnd Wirbel abreißen und vom strömenden Fluid mitgenommen werden. Diese Wirbel erzeugen lokale Druckschwankungen im Fluid, deren zeitbezogene Abriss-Häufigkeit, also deren sogenannte Wirbelfrequenz, ein Maß für die Strömungsgeschwindigkeit und/oder den Volumendurchfluss des Fluids ist. Der Volumendurchfluss ist per definitionem das pro Zeiteinheit durch jede Querschnittsfläche des Messrohrs strömende Volumen des Fluids.

Die Druckschwankungen werden mittels des Wirbelsensors 3 in mindestens ein die Druckschwankungen repräsentierendes Wirbelsignal umgeformt, das der erwähnten Auswerte-Elektronik zugeführt wird, die die Strömungsgeschwindigkeit und/oder den Volumendurchfluss des Fluids in üblicher Weise berechnet.

Der Wirbelsensor 3 ist stromabwärts vom Staukörper 4 in die Bohrung 22 der Rohrwand 21 des Messrohrs 2 eingesetzt und dichtet die Bohrung 22 zur Mantelfläche des Messrohrs 2 hin ab, wozu der Wirbelsensor 3 mit der Rohrwand 21 verschraubt ist. Hierzu dienen z.B. vier Schrauben, von denen in den Fig. 5 und 6 die Schrauben 5, 6, 7 zu sehen sind.

Vom Wirbelsensor 3 ist eine in den Fig. 5 und 6 in das Innere des Messrohrs 2 durch die Bohrung 22 der Rohrwand 21 hindurch ragende keilförmige Sensorfahne 31 und eine Gehäusekappe 32 zu sehen. Die Gehäusekappe 32 läuft unter Einfügung eines dünner-wandigen Zwischenstücks 323 in eine Verlängerung 322 aus, vgl. die erwähnte US-A 60 03 384.

Die Sensorfahne 31 hat Hauptflächen, von denen in den Fig. 5 und 6 nur die Hauptfläche 311 zu sehen ist. Die Hauptflächen fluchten mit der erwähnten Mantellinie des Messrohrs 2 und bilden eine Frontkante. Die Sensorfahne 31 kann auch andere geeignete Raumformen haben; so kann sie z.B. zwei parallele Hauptflächen aufweisen, die zwei parallele Frontkanten bilden. Die Sensorfahne 31 ist kürzer als der Durchmesser des Messrohrs 2 und ist biegesteif.

Anstatt dass der Wirbelsensor in die Rohrwand des Meßrohrs eingesetzt ist und er die Sensorfahne aufweist, kann der Wirbelsensor in einer Bohrung des Staukörpers angeordnet werden und ist dann anstatt mit der Senorfahne mit einer biegesteifen zylindrischen Sonde versehen.

Zur Unterdrückung von Stör- und Rauschsignalen, die auf den Wirbelsensor im Betrieb des Wirbel-Durchflussmessers aus unterschiedlichen Gründen einwirken können, enthält die in Fig. 7 dargestellte Auswerte-Elektronik üblicherweise eine Filter-Schaltung, die einen Hochpass und einen Tiefpass umfasst.

So ist zum Beispiel in der US-A 62 20 103 eine Auswerte-Elektronik für einen Wirbel-Durchflussmesser mit einem Messrohr beschrieben, die umfasst:

- einen Verstärker für mindestens ein Wirbelsignal,
- einen dem Verstärker nachgeschalteten Butterworth-Hochpass zweiter Ordnung,
- einen dem Butterworth-Hochpass nachgeschalteten Tschebyscheff-Tiefpass zweiter Ordnung,
- einen dem Tschebyscheff-Tiefpass nachgeschalteten Schmitt-Trigger,
- einen dem Schmitt-Trigger nachgeschalteten Zähler und
- eine dem Zähler nachgeschaltete Anzeige-Einheit.

Ferner ist in der US-A 56 39 964 eine Auswerte-Elektronik für einen Flugzeug-Außenbord-Geschwindigkeitsmesser beschrieben, von dem ein Wirbel-Durchflussaufnehmer an einer Außenwand des Flugzeugs angebracht ist, wobei die Auswerte-Elektronik umfasst:

- einen Bandpass oder
- einen Bandpass, dem ein Tiefpass parallelgeschaltet ist,
- einen dem Bandpass nachgeschalteten Effektivwert-Gleichrichter und
- eine dem Effektivwert-Gleichrichter nachgeschaltete Anzeige-Einheit,

    -- wobei der Bandpass aus einem Hochpassteil und einem Tiefpassteil besteht und
    -- wobei eine durch eine erste Sallen-Key-Schaltung eingestellte untere Bandgrenze eine Steigung von -12 dB/Frequenzoktave und eine durch eine zweite Sallen-Key-Schaltung eingestellte obere Bandgrenze eine Steigung von -12 dB/Frequenzoktave aufweist.

Die beiden vorbeschriebenen Auswerte-Elektroniken verwenden sowohl als Hochpass als auch als Tiefpass lediglich einfache zweipolige Filter, so dass die jeweilige Steilheit des Amplitudenverlaufs nur -20 dB/Frequenz-Zehnerpotenz beträgt, da gilt:
- 12 dB/Frequenzoktave = -20 dB/Frequenz-Zehnerpotenz.
Die Auswerte-Elektronik von Fig. 7 verwendet demgegenüber das aktive Tiefpassfilter der Erfindung.

Im Blockschaltbild der Fig. 7 ist der Wirbelsensor 3 mit dem Eingang eins Hochpasses hp gekoppelt. Ein Verstärker vk ist gestrichelt angedeutet, der zwischen einem Ausgang des Wirbelsensors 3 und einem Eingang des Hochpasses hp eingefügt sein kann, so dass das vom Wirbelsensor 3 abgegebene Wirbelssignal ausreichend verstärkt wird, bevor es zum Hochpass hp gelangt.

Dem Hochpass hp ist das aktive Tiefpassfilter tp nachgeschaltet, das aus den oben ausführlich erläuterten Filter-Teilschaltungen s1, s2 besteht. Dem Tiefpassfilter tp ist ein Schmitt-Trigger st nachgeschaltet, der aus dem am Ausgang des Tiefpassfilters tp auftretenden Signal, das i.a. ein Sinussignal ist, ein Rechtecksignal erzeugt. Schließlich ist dem Schmitt-Trigger st ein Zähler z und diesem eine Anzeige-Einheit dp und/oder ein Strommesser mi nachgeschaltet.

Durch die Verwendung des Tiefpassfilters tp in der Auswerte-Elektronik des Wirbeldurchflussmessers ist eine praktisch perfekte Unterdrückung aller vom Wirbelsensor 3 erzeugter Signale sichergestellt, deren Frequenzen oberhalb der Bandgrenze des Tiefpassfilters tp liegen.

Bei der Verwendung des Tiefpassfilters tp in der erläuterten Auswerte-Elektronik ist es besonders vorteilhaft, als Hochpass hp ein Tschebyscheff-Filter zweiter Ordnung mit 0,5 dB Überschwingen einzusetzen.

**Patentansprüche**

1.  Aktives Tiefpassfilter (tp), das mittels Widerständen, Kondensatoren und Operationsverstärkern realisiert ist und das umfasst:

    - eine mit einem zu filternden Wechselsignal gespeiste erste Filter-Teilschaltung (s1), die enthält:

        -- eingangsseitig eine erste Serienschaltung aus einem ersten Widerstand (W1) mit einem Widerstandswert R1 und aus einem zweiten Widerstand (W2) mit einem Widerstandswert R2, der ungefähr gleich dem Widerstandswert R1 ist,

        -- eine der ersten Serienschaltung parallelgeschaltete zweite Serienschaltung aus einem ersten Kondensator (K1) mit einer Kapazität C1 und einem zweiten Kondensator (K2) mit einer Kapazität C2, die ungefähr gleich der Kapazität C1 ist,

        -- einen den ersten und den zweiten Widerstand (W1, W2) mit einem Schaltungsnullpunkt (SN) verbindenden dritten Kondensator (K3) mit einer Kapazität C3, die mindestens fünfmal so groß wie die Kapazität C1 ist,

        -- einen den ersten und den zweiten Kondensator (K1, K2) mit dem Schaltungsnullpunkt (SN) verbindenden dritten Widerstand (W3) mit einem Widerstandswert R3, der groß gegenüber dem halben Widerstandswert R1 und groß gegenüber dem halben Widerstandswert R2 ist,

        -- einen vierten Widerstand (W4) mit einem Widerstandswert R4, der ungefähr gleich dem Widerstandswert R3 ist,

        -- einen vierten Kondensator (K4) mit einer Kapazität C4, die ungefähr gleich der Kapazität C1 ist,

        -- einen fünften Kondensator (K5) mit einer Kapazität C5,

        -- einen fünften Widerstand (W5) mit einem Widerstandswert R5,

        -- einen sechsten Widerstand (W6) mit einem Widerstandswert (k-1)R5,

        -- einen ersten Operationsverstärker (o1), von dem

            --- ein Ausgang über den fünften Kondensator (K5) am zweiten Widerstand (W2) und am zweiten Kondensator (K2) liegt,

            --- ein nicht-invertierender Eingang über den vierten Widerstand (W4) am zweiten Widerstand (W2), am zweiten Kondensator (K2) und am fünften Kondensator (K5) sowie über den vierten Kondensator (K4) am Schaltungsnullpunkt (SN) liegt und

            --- ein invertierender Eingang über den fünften Widerstand (W5) am Schaltungsnullpunkt (SN) sowie über den sechsten Widerstand (W6) am Ausgang liegt,

        -- wobei mit k die Spannungsverstärkung des ersten Operationsverstärkers (o1) bezeichnet ist, und

    - eine dem Ausgang des ersten Operationsverstärkers (o1) nachgeschaltete zweite Filter-Teilschaltung (s2) in Form eines Sallen-Key-Tiefpasses mit einem zweiten Operationsverstärker (o2).

2.  Aktives Tiefpassfilter nach Anspruch 1, bei dem der Sallen-Key-Tiefpass umfasst:

    - eine dritte Serienschaltung aus einem siebten Widerstand (W7) mit einem Widerstandswert R7 und aus einem achten Widerstand (W8) mit einem Widerstandswert R8,
    - einen neunten Widerstand (W9) mit einem Widerstandswert R9,

- einen zehnten Widerstand (W10) mit einem Widerstandswert (k'-1)R9,
- einen sechsten Kondensator (K6) mit einer Kapazität C6,
- einen siebten Kondensator (K7) mit einer Kapazität C7 und
- den zweiten Operationsverstärker (o2), von dem

-- ein Ausgang über den siebten Kondensator (K7) am siebten Widerstand (W7) sowie am achten Widerstand (W8) liegt und das gefilterte Wechselsignal abgibt,
-- ein nicht-invertierender Eingang über die dritte Serienschaltung am Ausgang des ersten Operationsverstärkers (o1) sowie über den sechsten Kondensator (K6) am Schaltungsnullpunkt liegt und
-- ein invertierender Eingang über den neunten Widerstand (W9) am Schaltungsnullpunkt (SN) sowie über den zehnten Widerstand (W10) am Ausgang liegt,
-- wobei mit k' die Spannungsverstärkung des zweiten Operationsverstärkers (o2) bezeichnet ist.

3. Auswerte-Elektronik mit einem aktiven Tiefpassfilter nach Anspruch 1 oder 2 für einen Wirbel-Durchflussmesser, von dem ein Wirbel-Durchflussaufnehmer (1) ein eine Rohrwand (21) aufweisendes und von einem zu messenden Fluid durchströmbares Messrohr (2) umfasst,

- in dem ein Staukörper (4) angeordnet ist, der

-- der Erzeugung Kármán'scher Wirbel im strömenden Fluid dient und
-- an mindestens einer Fixierstelle (41, 41*) mit der Rohrwand des Messrohrs von innen verbunden ist, und

- in dem ein auf von den Wirbeln erzeugte Druckschwankungen ansprechender und mindestens ein die Druckschwankungen repräsentierendes Wirbelsignal abgebender Wirbelsensor (3)

-- entweder stromabwärts vom Staukörper in eine Bohrung (22) der Rohrwand des Messrohrs eingesetzt ist und diese Bohrung abdichtet,
-- oder in einer Bohrung des Staukörpers angeordnet ist, welche Auswerte-Elektronik umfasst:

- einen dem Wirbelsensor (3) nachgeschalteten Hochpass (hp),
- das dem Hochpass (hp) nachgeschaltete aktive Tiefpassfilter (tp),
- einen dem Tiefpassfilter nachgeschalteten Schmitt-Trigger (st),
- einen dem Schmitt-Trigger (st) nachgeschalteten Zähler (z) und
- eine dem Zähler nachgeschaltete Anzeige-Einheit (dp).

4. Auswerte-Elektronik nach Anspruch 3, bei der der Hochpass (hp) ein Tschebyscheff-Filter zweiter Ordnung mit 0,5 dB Überschwingen ist.

**Claims**

1. Active low-pass filter (tp) which is realised by means of resistors, capacitors and operational amplifiers and which comprises:

- a first filter subcircuit (s1), which is fed with an alternating signal to be filtered and which includes:

-- on the input side, a first series circuit formed of a first resistor (W1) with a resistance value R1 and of a second resistor (W2) with a resistance value R2 approximately equal to the resistance value R1,
-- a second series circuit, which is connected in parallel with the first series circuit and is formed of a first capacitor (K1) with a capacitance C1 and of a second capacitor (K2) with a capacitance C2 approximately equal to the capacitance C1,
-- a third capacitor (K3), which connects the first and the second resistor (W1, W2) to a circuit zero point (SN) and has a capacitance C3 at least five times as great as the capacitance C1,
-- a third resistor (W3), which connects the first and the second capacitor (K1, K2) to the circuit zero point (SN) and has a resistance value R3 which is large relative to half the resistance value R1 and large relative to half the resistance value R2,
-- a fourth resistance (W4) with a resistance value R4 approximately equal to the resistance value R3,
-- a fourth capacitor (K4) with a capacitance C4 approximately equal to the capacitance C1,

-- a fifth capacitor (K5) with a capacitance C5,
-- a fifth resistor (W5) with a resistance value R5,
-- a sixth resistor (W6) with a resistance value (k-1)R5,
-- a first operational amplifier (o1), of which

--- an output is connected, via the fifth capacitor (K5), to the second resistor (W2) and to the second capacitor (K2),
--- a non-inverting input is connected, via the fourth resistor (W4), to the second resistor (W2), to the second capacitor (K2) and to the fifth capacitor (K5), and also, via the fourth capacitor (K4), to the circuit zero point (SN), and
--- an inverting input is connected, via the fifth resistor (W5), to the circuit zero point (SN) and also, via the sixth resistor (W6), to the output,

-- k denoting the voltage amplification of the first operational amplifier (o1), and

- a second filter subcircuit (s2), which is connected downstream of the output of the first operational amplifier (o1), is in the form of a Sallen-Key low-pass filter and has a second operational amplifier (o2).

2. Active low-pass filter according to Claim 1, in which the Sallen-Key low-pass filter comprises:

- a third series circuit formed of a seventh resistor (W7) with a resistance value R7 and of an eighth resistor (W8) with a resistance value R8,
- a ninth resistor (W9) with a resistance value R9,
- a tenth resistor (W10) with a resistance value (k'-1)R9,
- a sixth capacitor (K6) with a capacitance C6,
- a seventh capacitor (K7) with a capacitance C7, and
- the second operational amplifier (o2), of which

-- an output is connected, via the seventh capacitor (K7), to the seventh resistor (W7) and also to the eighth resistor (W8), and delivers the filtered alternating signal,
-- a non-inverting input is connected, via the third series circuit, to the output of the first operational amplifier (o1) and also, via the sixth capacitor (K6), to the circuit zero point, and
-- an inverting input is connected, via the ninth resistor (W9), to the circuit zero point (SN) and also, via the tenth resistor (W10), to the output,
-- k' denoting the voltage amplification of the second operational amplifier (o2).

3. Evaluating electronics having an active low-pass filter according to Claim 1 or 2 for a vortex flowmeter, of which a vortex flow transducer (1) comprises a measuring tube (2), which has a tube wall (21) and through which can flow a fluid to be measured,

- in which is arranged a damming body (4) which

-- serves to generate Kármán vortices in the flowing fluid and,
-- at at least one fixing point (41, 41*), is connected from inside to the tube wall of the measuring tube, and

- in which a vortex sensor (3), which responds to pressure variations produced by the vortices and delivers at least one vortex signal representing the pressure variations,

-- either is inserted, downstream of the damming body, into a bore (22) of the tube wall of the measuring tube and seals this bore,
-- or is arranged in a bore of the damming body, which evaluating electronics comprise:

- a high-pass filter (hp) connected downstream of the vortex sensor (3),
- the active low-pass filter (tp) connected downstream of the high-pass filter (hp),
- a Schmitt trigger (st) connected downstream of the low-pass filter,
- a counter (z) connected downstream of the Schmitt trigger (st), and
- a display unit (dp) connected downstream of the counter.

4. Evaluating electronics according to Claim 3, in which the high-pass filter (hp) is a second-order Chebyshev filter with 0.5 dB overshoot.

**Revendications**

1. Filtre passe-bas actif (tp), réalisé au moyen de résistances, de condensateurs et d'amplificateurs opérationnels, et qui comprend :

   - un sous-circuit de filtre (s1) alimenté par un signal alternatif à filtrer, lequel sous-circuit contient :

      -- un premier circuit série côté entrée, constitué d'une première résistance (W1) d'une valeur R1 et d'une deuxième résistance (W2) d'une valeur R2, qui est à peu près égale à la valeur R1,
      -- un deuxième circuit série couplé en parallèle avec le premier circuit série, composé d'un premier condensateur (K1) d'une capacité C1 et d'un deuxième condensateur (K2) d'une capacité C2, qui est à peu près égale à la capacité C1,
      -- un troisième condensateur (K3) d'une capacité C3, reliant la première et la deuxième résistance (W1, W2) au point zéro du circuit (SN), capacité qui est au moins égale à cinq fois la capacité C1,
      -- une troisième résistance (W3), reliant le premier et le deuxième condensateur (K1, K2) au point zéro du circuit (SN), d'une valeur R3, qui est grande par rapport à la demi-valeur de résistance R1 et grande par rapport à la demi-valeur de résistance R2,
      -- une quatrième résistance (W4) d'une valeur R4, qui est à peu près égale à la valeur R3,
      -- un quatrième condensateur (K4) d'une capacité C4, qui est à peu près égale à la capacité C1,
      -- un cinquième condensateur (K5) d'une capacité C5,
      -- une cinquième résistance (W5) d'une valeur R5,
      -- une sixième résistance (W6) d'une valeur (k-1)R5,
      -- un premier amplificateur opérationnel (o1), dont

         --- une sortie est reliée par le biais du cinquième condensateur (K5) à la deuxième résistance (W2) et au deuxième condensateur (K2),
         --- une entrée non inverseuse est reliée par le biais de la quatrième résistance (W4) à la deuxième résistance (W2), au deuxième condensateur (K2) et au cinquième condensateur (K5), ainsi que par le biais du quatrième condensateur (K4) au point zéro du circuit (SN), et
         --- une entre inverseuse est reliée par le biais de la cinquième résistance (W5) au point zéro du circuit (SN) et par le biais de la sixième résistance (W6) à la sortie,

      -- où k désigne l'amplification en tension du premier amplificateur opérationnel (o1), et

   - un deuxième sous-circuit de filtre (s2) couplé en aval de la sortie du premier amplificateur opérationnel (o1), sous la forme d'un filtre passe-bas de Sallen-Key doté d'un deuxième amplificateur opérationnel (o2).

2. Filtre passe-bas actif selon la revendication 1, pour lequel le filtre passe-bas de Sallen-Key comprend :

   - un troisième circuit série composé d'une septième résistance (W7) d'une valeur R7 et d'une huitième résistance (W8) d'une valeur R8,
   - une neuvième résistance (W9) d'une valeur R9,
   - une dixième résistance (W10) d'une valeur (k'-1)R9,
   - un sixième condensateur (K6) d'une capacité C6,
   - un septième condensateur (K7) d'une capacité C7 et
   - le deuxième amplificateur opérationnel (o2), dont

      -- une sortie est reliée par le biais d'un septième condensateur (K7) à la septième résistance (W7) ainsi qu'à la huitième résistance (W8) et délivre le signal alternatif filtré,
      -- une entrée non inverseuse est reliée par le biais du troisième circuit série à la sortie du premier amplificateur opérationnel (o1) ainsi que par le biais du sixième condensateur (K6) au point zéro du circuit, et
      -- une entrée inverseuse est reliée par le biais de la neuvième résistance (W9) au point zéro du circuit (SN) ainsi que par le biais de la dixième résistance (W10) à la sortie,
      -- où k' désigne l'amplification en tension du deuxième amplificateur opérationnel (o2).

3. Unité de traitement électronique pourvue d'un filtre passe-bas actif selon la revendication 1 ou 2, destinée à un débitmètre Vortex, dont un transmetteur de débit Vortex (1) entoure un tube de mesure (2) comportant une paroi de tube (21) et parcouru par le fluide à mesurer,

   - tube dans lequel est disposé un corps déflecteur (4), qui

      -- sert à générer un tourbillon de Karman dans le fluide en circulation et
      -- est relié de l'intérieur à au moins un point de fixation (41, 41*) avec la paroi du tube de mesure, et

   - dans lequel un capteur Vortex (3) adapté aux fluctuations de pression générées par les tourbillons et délivrant au moins un signal Vortex représentant les fluctuations de pression

      -- est soit inséré en aval du corps déflecteur, dans un alésage (22) de la paroi du tube, et assure l'étanchéité de cet alésage,
      -- est soit disposé dans un alésage du corps déflecteur,
      laquelle unité de traitement électronique comprend :

         - un filtre passe-haut (hp) couplé en aval du capteur Vortex (3),
         - le filtre passe-bas actif (tp) couplé en aval du filtre passe-haut (hp),
         - un trigger de Schmitt (st) couplé en aval du filtre passe-bas,
         - un compteur (z) couplé en aval du trigger de Schmitt (st), et
         - une unité d'affichage (dp) couplée en aval du compteur.

4. Unité de traitement électronique selon la revendication 3, pour laquelle le filtre passe-haut (hp) est un filtre de Tschebyscheff de deuxième ordre, avec une suroscillation de 0,5 dB.

Fig.1

Fig.2

Fig.3

EP 1 294 091 B1

Fig. 4

EP 1 294 091 B1

Fig.5

Fig.6

Fig.7

EP 1 294 091 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6003384 A
- US 6220103 A
- US 5639964 A

**In der Beschreibung aufgeführte Nicht-Patentliteratur**

- **P. HOROWITZ ; W. HILL.** *The Art of Electronics,* 1989, 263-284